# EUROPÄISCHE PATENTSCHRIFT

(11) **EP 2 357 395 B1**
(45) Veröffentlichungstag und Bekanntmachung des Hinweises auf die Patenterteilung: **09.05.2012**
(21) Anmeldenummer: 10152722.4
(22) Anmeldetag: 05.02.2010
(51) Int. Cl.: F21S 8/10, F21S 8/12

(54) **Leuchteinheit mit Lichtleiter**
Light unit with light guide
Unité d'éclairage avec conduit de lumière

(43) Veröffentlichungstag der Anmeldung: 17.08.2011
(73) Patentinhaber: Odelo GmbH, 71409 Schwaikheim (DE)
(72) Erfinder: Manth, Thomas, 52066 Aachen (DE); Olkay, Cem, 58454 Witten (DE); Kunze, Jochen, 47441 Moers (DE); Schwegler, Veit, 70372 Stuttgart (DE)
(74) Vertreter: Benninger, Johannes

(56) Entgegenhaltungen:
- EP-A2- 1 767 967
- DE-T2-602005 006 360
- US-A1- 2004 149 998
- US-A1- 2008 253 144
- US-A1- 2009 073 710

## Beschreibung

Die Erfindung betrifft eine Leuchteinheit gemäß dem Oberbegriff des Anspruchs 1.

Als Leuchtmittel für Leuchten, wie etwa Kraftfahrzeugleuchten, sind Leuchteinheiten bekannt, welche aus einer oder mehreren auf einem Leiterbahnträger angeordneten und elektrisch kontaktierten Leuchtdioden sowie einem oder mehreren derart gegenüber der zumindest einen Leuchtdiode angeordneten Lichtleitern bestehen, dass von wenigstens einer Leuchtdiode ausgestrahltes Licht kollimiert in eine Lichteintrittsfläche mindestens eines Lichtleiters eingekoppelt wird, um es an zumindest einer von der Lichteintrittsfläche entfernten, frei gestaltbaren Lichtaustrittsfläche des Lichtleiters wieder auszukoppeln. Bei dem Leiterbahnträger kann es sich z. B. um eine typischerweise ebene, plattenartige Platine, eine flexible Leiterbahnfolie oder um ein frei geformtes und mit Leiterbahnen versehenes Spritzgussteil handeln, um nur einige denkbare Ausgestaltungen zu nennen. Die Leuchtdiode besteht aus einem LED-Chip (LED; Lichtemittierende Diode) und einer zumindest in einer gewünschten Abstrahlrichtung transparenten Kapselung, z. B. in Form einer Umspritzung oder eines Vergusses. Es gibt z. B. bedrahtete Leuchtdioden zur Durchsteckmontage (THT; Through Hole Technology), oberflächenmontierbare (SMD; Surface Mounted Device) Leuchtdioden oder Leuchtdioden, bei denen der LED-Chip in Nacktmontagetechnik (COB; Chip On Board) direkt auf den Leiterbahnträger gebondet und anschließend mit einer transparenten Masse, z.B. einer Silikonmasse oder einem Kunststoff vergossen wird.

Um einen Lichtleiter effizient zu nutzen, wird im Allgemeinen kollimiertes Licht zur Einkopplung bevorzugt. Üblicherweise wird dies durch den Einsatz belinster, den Strahlengang einengender Leuchtdioden erreicht.

Durch EP 2 075 856 A2 ist eine oberflächenmontierbare SMD-Leuchtdiode bekannt, bestehend aus einem mit einer nichttransparenten Umspritzung versehenen Leadframe mit einem oder mehreren darauf angeordneten LED-Chips. Die Umspritzung hat eine in Abstrahlrichtung des mindestens einen LED-Chips divergente Öffnung. Am Grund der Öffnung ist der wenigstens eine LED-Chip auf dem Leadframe angeordnet. Die Öffnung ist durch eine in Abstrahlrichtung vor dem zumindest einen LED-Chip angeordnete und mit der Umspritzung verbundene transparente Linse verschlossen. Die Linse dient der Kollimation des vom LED-Chip ausgestrahlten Lichts. Die Linse hat eine oberhalb der Öffnung liegende, konvexe, sphärische Außenfläche und eine im jüngsten Querschnitt der divergenten Öffnung konkave Innenfläche. Die Außenseite ist auf einem um die Öffnung umlaufenden Rand auf der Umspritzung aufliegend angeordnet. Die Innenseite liegt auf dem Grund der Öffnung auf. Die konkave Innenfläche bildet am Grund der Öffnung eine Kavität, in welcher der LED-Chip Platz findet. Die Kavität ist mit einem Verkapselungsstoff verfüllt. Zwischen Außen- und Innenfläche bildet die Linse die divergente Form der Öffnung nach.

Nachteilig hieran ist, dass ein Lichtleiter, in dessen Lichteinkoppelfläche kollimiertes Licht einer solchen SMD-Leuchtdiode eingekoppelt werden soll, nur an einem Punkt der Außenfläche der Linse anliegend angeordnet werden kann, wohingegen der verbleibende Teil der Lichteinkoppelfläche mit Abstand zur Linse verbleibt. Ein solcher Abstand zieht einerseits Verluste im aus LED-Chip, Kavität mit Verkapselungsstoff, Linse zur Kollimation ausgestrahlten Lichts, optischem Übergang zwischen Linse und Lichteinkoppelfläche des Lichtleiters, Lichtleiter sowie optischem Übergang zwischen Lichtauskoppelfläche des Lichtleiters und Umgebung bestehenden optischen System nach sich. Andererseits wird durch einen solchen Abstand bei auf einem Leiterbahnträger angeordneter SMD-Leuchtdiode aufgrund des großen Abstands zwischen Leiterbahnträger und Lichteinkoppelfläche zusätzlich Bauraum benötigt.

Durch DE 10 2005 038 154 A1 ist eine Leuchteinheit für eine zusätzliche Bremsleuchte eines Kraftfahrzeugs bekannt. Die Leuchteinheit besteht aus mindestens drei auf einem plattenförmigen Leiterbahnträger angeordneten Leuchtdioden sowie einem stabförmigen Lichtleiter mit zwei Armen und einer sich über die beiden Arme erstreckenden Lichtauskoppelfläche. Der Lichtleiter hat in einem Zentralbereich zwischen den beiden Armen eine Ausnehmung. In der Ausnehmung ist der Leiterbahnträger mit den darauf angeordneten Leuchtdioden angeordnet. Die beiden äußeren Leuchtdioden strahlen in die jeweiligen stirnseitigen Lichteinkoppelflächen der benachbarten Arme, die wenigstens eine dazwischen angeordnete Leuchtdiode strahlt in Richtung der Lichtaustrittsfläche.

Anstelle der Leiterbahnträger mit den darauf angeordneten und elektrisch kontaktierten Leuchtdioden in einer Ausnehmung im Lichtleiter anzuordnen, ist außerdem bekannt, den Lichtleiter über ein anderes Bauteil indirekt mit dem Leiterbahnträger zu verbinden. Bei dem anderen Bauteil kann es sich z.B. um ein auf dem Leiterbahnträger angeordnetes Bauteil, oder um ein den Leiterbahnträger stützendes oder aufnehmendes Bauteil handeln, z. B. um ein Gehäuse einer Leuchte. Der Lichtleiter ist dabei derart an dem anderen Bauteil angeordnet, dass bei bestimmungsgemäßer Anordnung des anderen Bauteils gegenüber dem Leiterbahnträger die Lichteinkoppelfläche des Lichtleiters in Abstrahlrichtung mindestens einer auf dem Leiterbahnträger angeordneten und elektrisch kontaktierten Leuchtdiode liegt.

Eine solche Leuchteinheit ist durch DE 10 2007 013 024 A1 bekannt. Auf einem plattenartigen Leiterbahnträger sind Leuchtdioden angeordnet. Auf dem Leiterbahnträger ist ferner ein Gehäuse angeordnet, welches die Leuchtdioden umschließt. In dem Gehäuse sind Öffnungen deren Querschnitt der Kontur stirnseitiger Lichteinkoppelflächen eines langgestreckten, flexiblen Lichtleiters entsprechen. Der Lichtleiter ist mit seinen Lichteinkoppelflächen, die sich an dessen gegenüberliegenden Enden befinden, durch die Öffnungen ins Innere des Gehäuses geführt. Die Lichteinkoppelflächen sind in dem Gehäuse gegenüber den Leuchtdioden ausgerichtet. Der Lichtleiter ist mit seinen Enden in dem Gehäuse befestigt.

Des Weiteren kann der Lichtleiter z. B. durch Umspritzen eines oder mehrerer LED-Chips oder durch Anspritzen an eine oder mehrere Leuchtdioden integraler Bestandteil wenigstens einer Leuchtdiode sein. Dabei liegt die Lichteinkoppelfläche unmittelbar am LED-Chip bzw. an der transparenten Umspritzung der Leuchtdiode an und befindet sich innerhalb der integralen Baugruppe aus Lichtleiter und LED-Chip bzw. Leuchtdiode.

Bei besonders hohen erforderlichen Lichtstärken, welche nur mit hohem Strahlungsfluss erreicht werden können, ist das Anspritzen von Lichtleitern an LED-Chips oder Leuchtdioden jedoch nicht hinreichend, da bislang nur ein an einem Ende eines Lichtleiters angeordneter LED-Chip oder zwei, jeweils an gegenüberliegenden Enden des Lichtleiters angeordnete LED-Chips als Lichtquellen von einem Lichtleiter gemeinsam umspritzt werden können.

Deshalb werden insbesondere bei hohem erforderlichen Strahlungsfluss bisher zur Einkopplung in Lichtleiter durchsteckmontierte (THT) oder oberflächenmontierte (SMD) Leuchtdioden verwendet, die zu deren elektrischer Kontaktierung auf eine Platine bestückt sind.

Nachteilig hieran ist, dass sowohl durchsteckmontierte, als auch oberflächenmontierte Leuchtdioden einen bestimmten Aufbau entsprechender Tiefe vor dem Lichtleiter benötigen. Darüber hinaus ist eine beliebig enge Positionierung der Leuchtdioden aufgrund der räumlichen Ausdehnung deren transparenten Umspritzungen nicht möglich und damit die maximal erzielbare Strahlungsflussdichte begrenzt. Ein weiterer Nachteil ergibt sich durch die eingeschränkte Wärmeleitfähigkeit zwischen LED-Chip und Platine bei platinenmontierten Leuchtdioden. Diese ist gegeben durch die Wärmeleitfähigkeit des Chipträgers, z.B. eines Leadframes. Die thermisch isolierende Umspritzung trägt vernachlässigbar zur Wärmeabfuhr bei. Da der maximale Strahlungsfluss einer Leuchtdiode durch die maximal zulässige Temperatur des LED-Chips beschränkt ist, kann bei gegebener Wärmeleitfähigkeit nur ein Strahlungsfluss erzielt werden, bei dem die maximal zulässige Temperatur nicht überschritten wird.

Durch DE 60 2005 006 360 T2 ist eine Leuchteinheit mit einem Leiterbahnträger bekannt, welche mehrere auf dem Leiterbahnträger angeordnete und elektrisch kontaktierte LED-Chips sowie einen Lichtleiter umfasst. Der Lichtleiter hat mehrere Lichtleiterarme. Jeder der Lichtleiterarme hat jeweils eine in Abstrahlrichtung vor jeweils einer Gruppe von LED-Chips angeordnete Lichteinkoppelfläche. Die Lichteinkoppelflächen weisen identische, rechteckige Geometrien auf. Der Leiterbahnträger weist mehrere Ausnehmungen auf, auf deren Grund jeweils die einer Gruppe zugehörigen LED-Chips angeordnet und elektrisch kontaktiert sind. Jede der Ausnehmungen bildet die Kontur einer Lichteinkoppelfläche eines Lichtleiterarms nach. Jede Lichteinkoppelfläche deckt die ihr zugehörige Ausnehmung ab.

Durch die gattungsgemäße EP 1 767 967 A2 ist eine Leuchteinheit mit einem Leiterbahnträger bekannt, welche einen auf dem Leiterbahnträger angeordneten und elektrisch kontaktierten LED-Chip sowie einen Lichtleiter umfasst. Der Lichtleiter verfügt über eine in Abstrahlrichtung vor dem LED-Chip angeordneten Lichteinkoppelfläche. Der Leiterbahnträger weist eine Ausnehmung auf, auf deren Grund der LED-Chip angeordnet und elektrisch kontaktiert ist. Die Lichteinkoppelfläche stellt die gesamte dem LED-Chip zugewandte Fläche des Lichtleiters dar. Die Ausnehmung ist größer bemessen, als die Lichteinkoppelfläche des Lichtleiters. Der Lichtleiter reicht mit seiner Lichteinkoppelfläche in die Ausnehmung. Am Grund der Ausnehmung sind Fortsätze angeordnet, welche den Lichtleiter in Abstrahlrichtung von dem LED-Chip beabstanden, so dass die Lichteinkoppelfläche nicht auf dem LED-Chip aufsitzt. Die Ausnehmung ist dabei nur innerhalb einer Partie, welche einen um den LED-Chip herum liegenden und durch die Fortsätze begrenzten Bereich umfasst von der Lichteinkoppelfläche des Lichtleiters abgedeckt.

Bisherige Lösungsansätze mit denen versucht werden soll, die beschriebenen Nachteile zu umgehen, sehen eine Verwendung kleiner, dadurch zwar eng positionierbarer aber auch lichtschwacher Leuchtdioden vor, oder eine Verwendung von dünnem Platinenmaterial zur räumlich engen Ankopplung der Leuchtdioden an den Lichtleiter. Dennoch kann der Abstand zwischen der Lichteinkoppelfläche des Lichtleiters und dunklem Aufbau des Leiterbahnträgers mit darauf angeordneten und elektrisch kontaktierten Leuchtdioden mit der bekannten Technologie nicht beliebig dünn gemacht werden.

Eine Aufgabe der Erfindung ist es, eine Leuchteinheit mit hohem Strahlungsfluss bei hoher Strahlungsflussdichte zu entwickeln.

Die Aufgabe wird gelöst durch die Merkmale des Anspruchs 1.

Demnach ist eine Leuchteinheit vorgesehen, welche einen Leiterbahnträger, wenigstens einen auf dem Leiterbahnträger angeordneten und elektrisch kontaktierten LED-Chip und mindestens einem Lichtleiter mit zumindest einer in Abstrahlrichtung vor wenigstens einem LED-Chip angeordneten Lichteinkoppelfläche umfasst. Über die Lichteinkoppelfläche gelangt von dem wenigstens einen LED-Chip ausgestrahltes Licht zu dessen Auskopplung in den mindestens einen Lichtleiter. Das so eingekoppelte Licht wird an wenigstens einer entfernten Lichtauskoppelfläche des Lichtleiters wieder ausgekoppelt. Erfindungsgemäß ist vorgesehen, dass der Leiterbahnträger mindestens eine Ausnehmung aufweist, auf deren Grund wenigstens ein LED-Chip angeordnet und elektrisch kontaktiert ist. Die mindestens eine Ausnehmung bildet die Kontur zumindest einer Lichteinkoppelfläche mindestens eines Lichtleiters nach. Zumindest eine lichteinkoppelflächenseitige Partie mindestens eines Lichtleiters deckt die mindestens eine Ausnehmung wenigstens ab. Der wenigstens eine am Grund der mindestens einen Ausnehmung angeordnete und elektrisch kontaktierte LED-Chip ist in Nacktchipmontage (COB; Chip On Board) unmittelbar auf den Leiterbahnträger gebondet.

Zumindest ein Teil der zumindest eine Ausnehmung abdeckenden lichteinkoppelflächenseitigen Partie mindestens eines Lichtleiters reicht in die Ausnehmung. Beispielsweise kann zumindest ein Teil der zumindest eine Ausnehmung abdeckenden lichteinkoppelflächenseitigen Partie in der Ausnehmung aufgenommen sein.

An dem Leiterbahnträger und/oder an dem Lichtleiter sind miteinander korrespondierende Ausrichtungsmittel zur fluchtenden Ausrichtung der Lichteinkoppelfläche des Lichtleiters gegenüber dem mindestens einen am Grund der wenigstens einen Ausnehmung des Leiterbahnträgers angeordneten LED-Chip vorgesehen.

Die mindestens eine Ausnehmung kann konturfolgend jeder beliebigen Form einer Lichteinkoppelfläche eines Lichtleiters folgend ausgestaltet werden. Insbesondere können mehrere LED-Chips in einer Ausnehmung angeordnet werden.

Es können ein oder mehrere Lichtleiter je Leiterbahnträger aufgenommen bzw. aufgebracht sein. Es können mehrere einzelne Ausnehmungen in den Leiterbahnträger eingebracht sein, um mehrere separate Lichtleiter aufzunehmen und Licht in diese einzukoppeln. Am Grund jeder einzelnen Ausnehmung ist dabei wenigstens ein LED-Chip angeordnet.

So können eine oder mehrere Ausnehmungen mit einem oder mehreren LED-Chips auf einem Leiterbahnträger vorgesehen sein.

Die zumindest eine Ausnehmung kann so ausgeformt sein, dass der Abstand zwischen dem mindestens einen am Grund der Ausnehmung angeordneten und elektrisch kontaktierten LED-Chip und wenigstens einer Wandung der Ausnehmung vorzugsweise kleiner als 2 mm, bevorzugt kleiner als 1 mm und besonders bevorzugt kleiner als 0,5 mm ist.

Wenigstens eine Wandung zumindest einer Ausnehmung kann senkrecht, winkelig nach innen oder winkelig nach außen zur Oberfläche des Leiterbahnträgers verlaufend ausgeformt sein.

Der Leiterbahnträger kann beispielsweise plattenartig sein, oder eine beliebige, z. B. konturfolgende Form aufweisen. Als plattenartige Leiterbahnträger können beispielsweise Metallkernplatinen mit einer die Ausnehmung bildenden Ausfräsung, mehrlagige FR4-Platinen oder Keramikplatinen verwendet werden.

Bei einer Ausgestaltung mit einer mehrlagigen FR4-Platine, z. B. mit vier Kupferlagen, stehen für die Wärmeabfuhr zusätzliche Kupferschichten zur Verfügung, welche die Wärmeübertragung vom LED-Chip an die Umgebung verbessern, indem sie den thermischen Widerstand vom LED-Chip an die Umgebung weiter verringern.

Der Lichtleiter kann beliebig geformt sein, insbesondere im Hinblick auf die Querschnittsgeometrie.

So können beispielsweise sowohl Flächenlichtleiter, als auch elliptische oder runde Lichtleiter mit ihrer lichteinkoppelflächenseitigen Partie in der zumindest einen Ausnehmung aufgenommen werden. Die Ausnehmung bildet die jeweilige Kontur entsprechend nach.

Der Lichtleiter kann beispielsweise durch Spritzgießen oder durch Extrudieren hergestellt sein.

Die zumindest eine Ausnehmung im Leiterbahnträger kann z. B. mittels eines Laser-Bearbeitungsschrittes bei der Leiterbahnträgerherstellung, z. B. bei der Platinenherstellung eingefügt werden. Ebenfalls ist denkbar, die zumindest eine Ausnehmung im Leiterbahnträger durch Fräsen oder Stanzen herzustellen.

Es ist ersichtlich dass die Erfindung z. B. durch eine Elektronikplatine verwirklicht werden kann, auf der mindestens ein LED-Chip in Nacktmontagetechnik in einer beliebig geformten Ausnehmung gebondet wird. Mehrere LED-Chips können in einer beispielsweise gekrümmt ausgearbeiteten Ausnehmung konturfolgend einem Flächenlichtleiter oder mehreren Einzellichtleitern aufgebaut werden. Der Abstand der LED-Chips kann z. B. entsprechend den Designrichtlinien der Platinenhersteller sehr gering ausgestaltet werden. Beispielsweise sind Abstände von weniger als 1 mm von LED-Chip zu LED-Chip denkbar. Die Platinendicke ist somit gleichzeitig die Dicke des Gesamtaufbaus vor dem Lichtleiter.

Vorteile der Erfindung gegenüber dem Stand der Technik ergeben sich unter anderem dadurch, dass aufgrund des im Vergleich zu einer Aneinanderreihung von Leuchtdioden engeren Abstands von LED-Chips zueinander eine deutlich höhere Strahlungsflussdichte und damit deutlich mehr Licht pro Querschnitts- bzw. Stirnfläche des Lichtleiters eingekoppelt werden kann, so dass der aus dem Lichtleiter auskoppelbare Strahlungs- bzw. Lichtfluss bei gleicher Querschnittsfläche erhöht wird. Auf diese Weise ist es möglich, auch bei geringen Querschnitten Signalfunktionen in einer Leuchte, wie z. B. Brems-, Blink-, Nebelschlusslicht, in Lichtleitertechnologie zu verwirklichen. Der derart einkoppelbare Lichtstrom wird somit um einen Faktor von größer zwei zu derzeitigen Lösungen erhöht. Die erfindungsgemäße Leuchteinheit weist ferner ihre im Vergleich zum Stand der Technik höhere Lichteinkoppeleffizienz in den Lichtleiter bei gleichzeitig geringem Bauvolumen und einfacher Herstellbarkeit auf.

Durch den Verzicht auf nach dem Stand der Technik erforderlicher Leuchtdioden mit z. B. integrierter Linse zur Kollimation des vom LED-Chip der Leuchtdiode ausgestrahlten Lichts und durch die Nacktchipmontage von LED-Chips in der Ausnehmung ermöglicht die Erfindung LED-Chips in sehr geringem Abstand setzen zu können, wodurch eine im Vergleich zum Stand der Technik höhere Strahlungsflussdichte aus eingekoppeltem Lichtfluss pro Lichtleiter-Querschnittsfläche erreicht wird.

Ferner ermöglicht die Erfindung z. B. für Kraftfahrzeugleuchten mit geringer Bautiefe nach dem Stand der Technik konträre Forderungen zu erfüllen, nämlich einerseits einen flachen Aufbau zu schaffen und andererseits dennoch eine lichtstarke Einkopplung in einen Lichtleiter zu erreichen. Beispielsweise kann mit Hilfe der Erfindung eine einfache Leuchte bereitgestellt werden, etwa eine hochgesetzte dritte Bremsleuchte, welche nur aus einer erfindungsgemäßen Leuchteinheit besteht.

Dies wird unter Anderem dadurch erreicht, dass durch die Anordnung mindestens eines LED-Chips in einer Ausnehmung in direkter Chipnähe bzw. Chipumgebung eine Kollimation des ausgestrahlten Lichts erfolgt. Die Ausnehmung wirkt hierbei wie ein die Lichtstrahlen ausrichtender Reflektor. Hierdurch kann eine nach dem Stand der Technik zur Kollimation erforderliche Linse entfallen. Die Anordnung wenigstens eines LED-Chips in einer Ausnehmung ermöglicht zudem, ohne zusätzlichen Bauraumbedarf und ohne eine nach dem Stand der Technik erfolgende Verschlechterung des eingangs geschilderten optischen Systems, hier bestehend aus LED-Chip, die Kollimation ausgestrahlten Lichts bewirkender Ausnehmung mit gegebenenfalls darin eingebrachter transparenter Vergussmasse, unmittelbar an die Ausnehmung bzw. die gegebenenfalls in diese eingebrachte transparente Vergussmasse anschließender Lichteinkoppelfläche des Lichtleiters, Lichtleiter sowie optischem Übergang zwischen Lichtauskoppelfläche des Lichtleiters und Umgebung, einen Lichtleiter mit gegenüber dem Stand der Technik deutlich verringerter Bautiefe unmittelbar vor wenigstens einem LED-Chip im Strahlenweg des von dem LED-Chip ausgestrahlten und anschließend kollimierten Lichts anzuordnen.

Weitere Vorteile der Erfindung gegenüber dem Stand der Technik ergeben sich durch die Nacktchipmontage. Bei der Nacktchipmontage werden die LED-Chips direkt auf die Platine gebondet, wodurch eine Begrenzung der Wärmeleitfähigkeit zwischen LED-Chip und Leiterbahnträger durch den Chipträger, z. B. einen Leadframe entfällt. Dies führt zu einer guten Wärmeankopplung des LED-Chips, was wiederum zu einer geringen Degradation der vom LED-Chip emittierten Lichtleistung aufgrund der geringeren Erwärmung führt. Der thermische Widerstand von LED-Platinen mit einzelnen SMD- oder THT-LEDs ist zu einem Großteil bestimmt durch den Chipträger, z. B. einen Leadframe. Da bei COB Leuchtdioden die LED-Chips direkt auf den Leiterbahnträger gebondet werden, entfällt dieser Teil des thermischen Widerstands. Die Wärmeableitung ist bei der erfindungsgemäßen Leuchteinheit aufgrund der direkten Bondung des LED-Chips auf den Leiterbahnträger optimiert. Sich hieraus ergebende Vorteile sind eine geringe Wärmedegradation, was wiederum zu einer hohen optischen Effizienz führt.

Bisher nach dem Stand der Technik übliche nacktchipmontierte bzw. COB-Leuchtdioden weisen neben dem eigentlichen LED-Chip eine vorgesetzte Silikonlinse zum Schutz des LED-Chips auf und sind aufgrund der freiliegenden Silikon-Linse empfindlich gegenüber äußerer Krafteinwirkung. Durch das Absenken der LED-Chips in den Leiterbahnträger, was durch die Anordnung der LED-Chips am Grund der auf dem Leiterbahnträger vorgesehenen Ausnehmung vorgenommen ist, wird durch die Erfindung die Druckempfindlichkeit nacktchipmontierter LED-Chips gegenüber nachtchipmontierter Leuchtdioden nach dem Stand der Technik deutlich verringert.

Eine vorteilhafte Ausgestaltung der Erfindung sieht vor, dass die Wandungen der Ausnehmung mit einer reflektierenden Beschichtung versehen sind. Die Wandungen der wenigstens eine Ausnehmung können beispielsweise mit Metall beschichtet sein, um das von dem mindestens einen LED-Chip am Grund der Ausnehmung ausgestrahlte Licht in der Ausnehmung hin zur Lichteinkoppelfläche des Lichtleiters bevorzugt unter gleichzeitiger Kollimation zu reflektieren. Ebenso ist denkbar, dass die Wandungen mit Kunststoff beschichtet sind, um das Licht in der Ausnehmung zu reflektieren. Durch die reflektierende Beschichtung werden Absorptionsverluste in der Ausnehmung verringert und die Kollimationswirkung der Ausnehmung auf das von dem mindestens einen am Grund der Ausnehmung angeordneten LED-Chip verbessert.

Eine vorteilhafte Ausgestaltung der Erfindung sieht an dem Leiterbahnträger und/oder an wenigstens einem Lichtleiter angeordnete Befestigungsmittel zur mechanischen Kopplung und Verbindung von Lichtleiter und Leiterbahnträger vor. In den Leiterbahnträger kann z.B. eine Fräsung oder Bohrung eingebracht sein zur unkomplizierten Ankopplung an den Lichtleiter. Denkbar sind z.B. durch Fräsen oder Bohren hergestellte Bohrungen, Ausnehmungen, Öffnungen, Hintergreifungen. Solche Geometrien können auch bereits durch Verwendung einer geeigneten Form bei der Herstellung von Lichtleiter und/oder Leiterbahnträger erzeugt werden, wodurch ein zusätzlicher Arbeitsschritt, wie etwa Fräsen oder Bohren, eingespart werden kann. Alternativ oder zusätzlich können auch Klippsverbindungen, Einpressstifte, Warmverstemm-Stifte vorgesehen sein, die beispielsweise mit Bohrungen, Ausnehmungen, Öffnungen, Hintergreifungen korrespondieren.

Eine vorteilhafte Ausgestaltung der Erfindung sieht vor, dass die Befestigungsmittel an dem Leiterbahnträger und an dem Lichtleiter angeordnete, miteinander korrespondierende Rastmittel zur Verrastung von Lichtleiter und Leiterahnträger umfassen.

Beispielsweise können die miteinander korrespondierenden Rastmittel von Leiterbahnträger und Lichtleiter in der Ausnehmung und an der in der Ausnehmung aufgenommenen lichteinkoppelflächenseitigen Partie des Lichtleiters vorgesehen sein. Hierdurch wird eine Verrastung des Lichtleiters in der Ausnehmung erzielt. Deckt die lichteinkoppelflächenseitige Partie des Lichtleiters die Ausnehmung lediglich ab und ragt nicht in die Ausnehmung hinein, so können korrespondierende Rastmittel auf der die Öffnung der Ausnehmung aufweisenden Seite des Leiterbahnträgers und z.B. an einer an die Lichteinkoppelfläche angrenzenden Mantelfläche des Lichtleiters angeordnet sein. Ebenfalls sind Kombinationen beider Maßnahmen denkbar.

Die Rastmittel schaffen beispielsweise die Möglichkeit, die Leuchteinheit auf besonders einfache Weise vorzumontieren. Sich hierdurch ergebende Vorteile sind z.B. dass durch eine Vormontage von Leiterbahnträger und Lichtleiter zu einer gemeinsamen Baugruppe, z.B. durch Kleben oder Klipsen, ein einfacherer und schnellerer Einbau z.B. in einem Fahrzeug möglich ist.

Beispielsweise können bei einem in die Ausnehmung ragenden Teil der lichteinkoppelseitigen Partie des Lichtleiters in der Ausnehmung und an dem in der Ausnehmung aufgenommenen Teil der lichteinkoppelflächenseitigen Partie des Lichtleiters miteinander korrespondierende Ausrichtungsmittel zur mit dem wenigstens einen am Grund der Ausnehmung angeordneten LED-Chip fluchtenden Ausrichtung der Lichteinkoppelfläche des Lichtleiters in der Ausnehmung vorgesehen sein. Deckt die lichteinkoppelflächenseitige Partie lediglich die Ausnehmung ab, können beispielsweise am Rand der Ausnehmung oder neben dem Rand der Ausnehmung oder auf der die Öffnung der Ausnehmung aufweisenden Seite des Leiterbahnträgers und an entsprechenden an den genannten Stellen angrenzenden Flächen des Lichtleiters korrespondierende Ausrichtmittel angeordnet bzw. vorgesehen sein.

Die Ausrichtungsmittel können gleichzeitig durch den Lichtleiter mit dem Leiterbahnträger verrastende Rastmittel gebildet werden oder umgekehrt.

Die Ausrichtungsmittel können beispielsweise durch Zentrierbohrungen oder -fräsungen im Leiterbahnträger gebildet sein. Hierdurch kann eine besonders exakte Positionierung des Lichtleiters relativ zu der durch den wenigstens einen am Grund der Ausnehmung angeordneten LED-Chip gebildeten Lichtquelle erreicht werden. Diese niedrige mechanische Toleranz erhöht die Effizienz der Einkopplung zwischen Lichtquelle und Lichtleiter im Vergleich zu herkömmlichen Leuchteinheiten nach dem Stand der Technik.

Wichtig ist hervorzuheben, dass auch ein in der Ausnehmung aufgenommener bzw. ein in die Ausnehmung ragender Teil der lichteinkoppelflächenseitigen Partie als ein Ausrichtungsmittel dienen kann.

Eine vorteilhafte Ausgestaltung der Erfindung sieht vor, dass ein zwischen dem Grund der Ausnehmung und der Lichteinkoppelfläche innerhalb der Ausnehmung verbleibender Raum mit einer transparenten Vergussmasse verfüllt ist. Dadurch wird das optische System weiter verbessert, da ein ansonsten gegebenenfalls vorhandener, aus Sicht des optischen Systems besonders verlustbehafteter optischer Übergang zwischen dem LED-Chip, einem beispielsweise ansonsten in der Ausnehmung verbleibenden gasförmigen Medium, wie etwa Luft, und dem Lichtleiter durch gezielte Vergussmassematerialwahl vermieden werden kann.

Eine andere, besonders vorteilhafte Ausgestaltung der Erfindung sieht vor, dass die Ausnehmung oder zumindest ein Teil der Ausnehmung mit einer transparenten Vergussmasse gefüllt ist, z.B mit Silikon oder einem anderem transparenten Material, vorzugsweise einem transparenten Kunststoff. Beispielsweise kann die Ausnehmung vollständig oder in einem Querschnitt durch den Leiterbahnträger und die Ausnehmung betrachtet sogar leicht über den Rand der Ausnehmung konvex herauswölbend mit einer vorzugsweise elastischen, gegebenenfalls auch kompressiblen transparenten Vergussmasse verfüllt werden. Auf die Vergussmasse presst dann bei fertig montierter Leuchteinheit die Lichteinkoppelfläche des Lichtleiters. Dadurch werden die Effizienz des optischen Systems nachteilig beeinflussende Gaszwischenräume zwischen Vergussmasse und Lichteinkoppelfläche beseitigt bzw. vermieden.

Eine zusätzliche vorteilhafte Ausgestaltung der Erfindung sieht vor, dass die Lichteinkoppelfläche wenigstens eine konkave Aussparung aufweist. In die konkave Aussparung kann bei in die Ausnehmung aufgenommenem Lichtleiter der wenigstens eine LED-Chip ragen, oder es kann z. B. bei die Ausnehmung wenigstens abdeckender lichteinkoppelflächenseitiger Partie des Lichtleiters eine gegebenenfalls vorgesehene, zur Verfüllung der Ausnehmung dienende transparente Vergussmasse in die konkave Aussparung reichen.

Sind zwei oder mehr LED-Chips am Grund einer Ausnehmung angeordnet und elektrisch kontaktiert, können diese einem Abstand von weniger als 2 mm, bevorzugt von weniger als 1 mm zueinander angeordnet sein. Alternativ können sie auch in einem Abstand zueinander angeordnet werden, der größer ist, als 2 mm. Die Abstände zwischen mehreren am Grund einer Ausnehmung angeordneten LED-Chips können besonders bevorzugt weniger als 1 mm betragen, wodurch eine hohe Packungsdichte und eine damit einhergehende hohe Strahlungsflussdichte bzw. Lichtflussdichte erreicht werden kann.

Weitere Merkmale der Erfindung ergeben sich aus den weiteren Ansprüchen, der Beschreibung und den Zeichnungen.

Die Erfindung wird nachstehend anhand von in den Zeichnungen dargestellten Ausführungsbeispielen näher erläutert. Darin bezeichnen gleiche Bezugszeichen gleiche oder gleich wirkende Elemente. Es zeigen:
- Fig. 1: einen Schnitt durch einen Leiterbahnträger einer Leuchteinheit.
- Fig. 2: eine schematische Darstellung eines ersten Ausführungsbeispiels einer Leuchteinheit in perspektivischer Ansicht.
- Fig. 3: eine schematische Darstellung eines zweiten Ausführungsbeispiels einer Leuchteinheit in perspektivischer Ansicht.
- Fig. 4: eine schematische Darstellung eines dritten Ausführungsbeispiels einer Leuchteinheit in perspektivischer Ansicht.
- Fig. 5: eine schematische Darstellung eines Leiterbahnträgers eines vierten Ausführungsbeispiels einer Leuchteinheit in perspektivischer Ansicht.
- Fig. 6: eine schematische Darstellung der Leuchteinheit gemäß dem vierten Ausführungsbeispiel in einer Seitenansicht.
- Fig. 7: eine schematische Darstellung der Leuchteinheit gemäß dem vierten Ausführungsbeispiel in perspektivischer Ansicht.

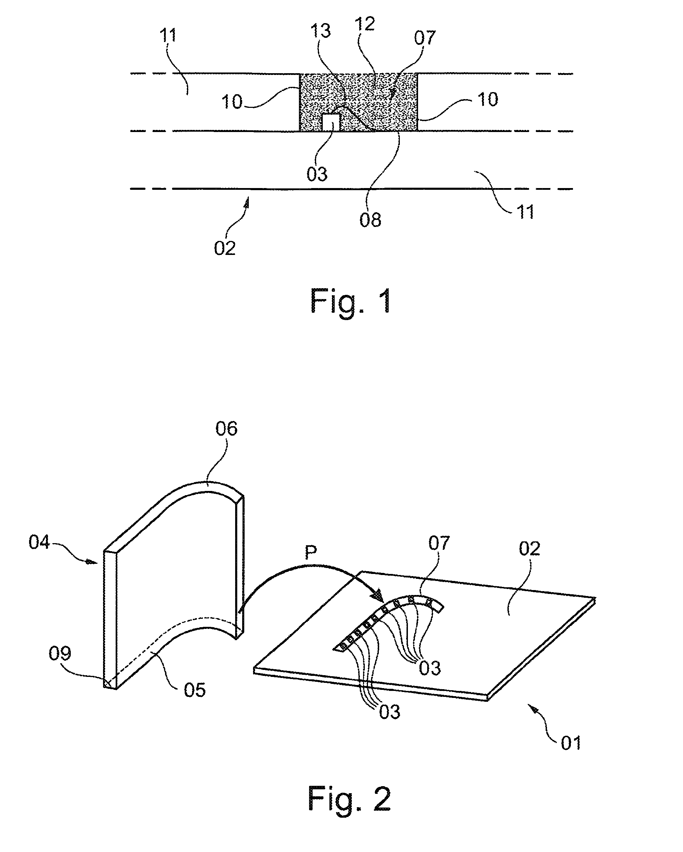

Eine in den Fig. 1 bis 7 ganz oder in Teilen dargestellte Leuchteinheit 01 besteht im Wesentlichen aus einem Leiterbahnträger 02, wenigstens einen auf dem Leiterbahnträger 02 angeordneten und elektrisch kontaktierten LED-Chip 03 und mindestens einem Lichtleiter 04 mit zumindest einer in Abstrahlrichtung vor wenigstens einem LED-Chip 03 angeordneten Lichteinkoppelfläche 05. Über die Lichteinkoppelfläche 05 gelangt von dem wenigstens einen LED-Chip 03 ausgestrahltes Licht in den Lichtleiter 04. Das so eingekoppelte Licht wird an wenigstens einer entfernten Lichtauskoppelfläche 06 des Lichtleiters 04 wieder ausgekoppelt. Der Leiterbahnträger 02 weist mindestens eine Ausnehmung 07 auf, auf deren Grund 08 wenigstens ein LED-Chip 03 in Nacktchipmontagetechnik (COB; Chip On Board) angeordnet und elektrisch kontaktiert ist. Die mindestens eine Ausnehmung 07 bildet die Kontur zumindest einer Lichteinkoppelfläche 06 mindestens eines Lichtleiters 04 nach.

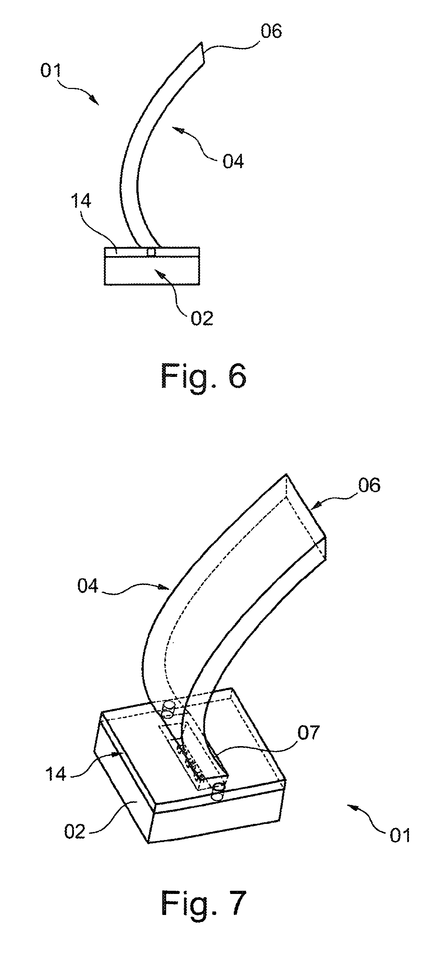

Zumindest eine lichteinkoppelflächenseitige Partie 09 des mindestens einen Lichtleiters 04 deckt die mindestens eine Ausnehmung 07 wie in den Fig. 2, 3 und 4 durch die Pfeile P angedeutet und wie in den Fig. 6 und 7 dargestellt wenigstens ab.

Ein Teil der lichteinkoppelflächenseitigen Partie 09 des mindestens einen Lichtleiters 04 kann dabei in der mindestens einen Ausnehmung 07 aufgenommen sein.

Die Ausnehmung 07 bildet dabei die jeweilige Kontur zumindest einer Lichteinkoppelfläche 05 derart entsprechend nach, dass z. B. in einer Draufsicht die Form der Lichteinkoppelfläche 05 nachgebildet wird, und z. B. im Querschnitt die Form der lichteinkoppelflächenseitigen Partie 09 des Lichtleiters 04. So können beispielsweise sowohl Flächenlichtleiter 04, als auch elliptische oder runde Lichtleiter 04 mit ihrer lichteinkoppelflächenseitigen Partie 09 in der zumindest einen Ausnehmung 07 aufgenommen werden.

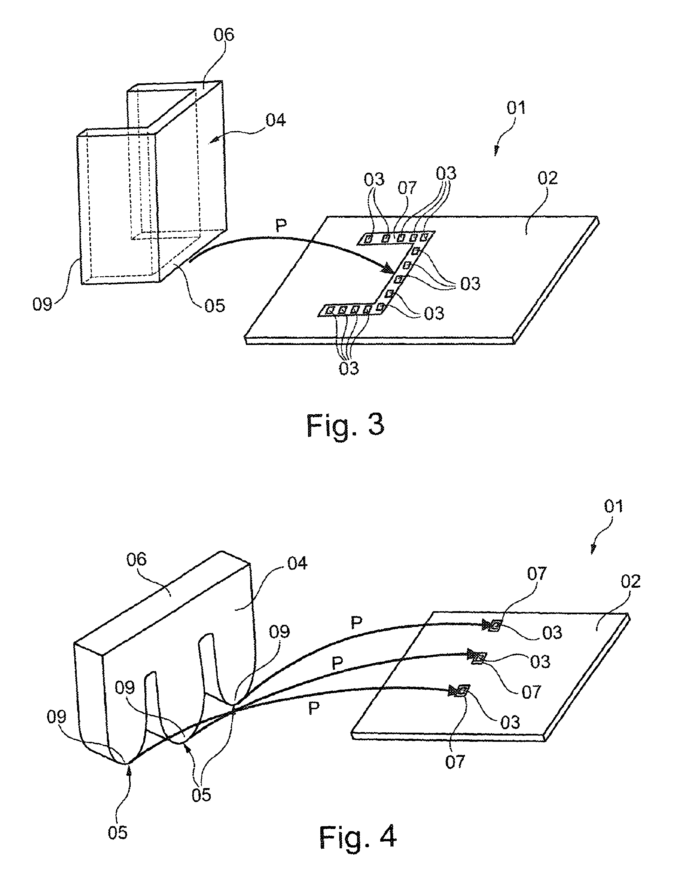

Die mindestens eine Ausnehmung 07 kann wie in den Fig. 2, 3, 4, 5 und 7 zu erkennen konturfolgend jeder beliebigen Form einer Lichteinkoppelfläche 05 eines Lichtleiters 04 folgend ausgestaltet werden. Ein konturfolgender Aufbau für einen beliebig geformten Flächen-Lichtleiter (Fig. 2, 3, 6 und 7) ist ebenso möglich, wie ein Aufbau mit mehreren nebeneinander liegenden Ausnehmungen 07 für die einzelnen Lichteinkoppelflächen 05 eines Lichtleiters 04 (Fig. 4). Ebenso ist ein Aufbau mit mehreren nebeneinander liegenden Ausnehmungen 07 für einzelne Lichtleiter 04 eines Lichtleiter-Bündels möglich.

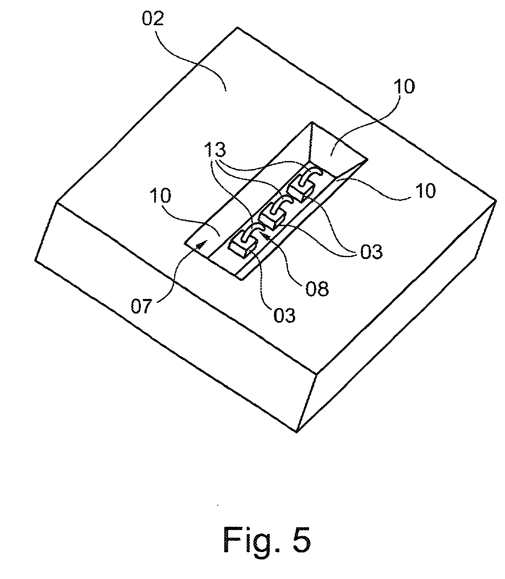

Zumindest eine Wandung 10 der Ausnehmung 07 kann dabei wie in Fig. 5 zu erkennen winklig nach außen zur Oberfläche des Leiterbahnträgers 02 verlaufend ausgeformt sein, so dass die Ausnehmung 07 von ihrem Grund 08 aus gesehen divergent verläuft. Alternativ kann wenigstens eine Wandung 10 wie in Fig. 1 dargestellt senkrecht verlaufen oder winkelig nach innen zur Oberfläche des Leiterbahnträgers 02 verlaufend ausgeformt sein. Insbesondere durch eine divergente Ausgestaltung der Ausnehmung durch winklig nach außen zur Oberfläche des Leiterbahnträgers 02 verlaufende Wandungen 10 (Fig. 5) wird zum einen eine gute Kollimation des von dem mindestens einen am Grund 08 der Ausnehmung 07 angeordneten LED-Chips 03 ausgestrahlten Lichts sichergestellt. Ragt ein Teil der lichteinkoppelflächenseitigen Partie 09 in die Ausnehmung wird durch die winklig nach außen zur Oberfläche des Leiterbahnträgers 02 verlaufende Wandungen 10 andererseits sehr einfach eine Passform erzeugt, so dass der Lichtleiter 04 und der Leiterbahnträger 02 der Leuchteinheit 01 einfach und sicher positionsgenau zu montieren sind. Ein gegebenenfalls in der Ausnehmung 07 aufgenommener bzw. ein in die Ausnehmung 07 ragender Teil der lichteinkoppelflächenseitigen Partie 09 dient so als ein Ausrichtungsmittel. Ein sich hierdurch ergebender Vorteil ist, dass Maßungenauigkeiten einen nur geringen Einfluss auf die Ausrichtgenauigkeit der Lichteinkoppelfläche 05 in Abstrahlrichtung der LED-Chips 03 hat, die einzuhaltenden Toleranzen also nicht besondere Anforderungen stellen.

Die Wandungen 10 der Ausnehmung 07 können mit einer reflektierenden Beschichtung beispielsweise aus z.B. aufgedampften Metall oder aus Kunststoff versehen sein, um das von dem mindestens einen LED-Chip 03 am Grund 08 der Ausnehmung 07 ausgestrahlte Licht in der Ausnehmung 07 in die Lichteinkoppelfläche 05 des Lichtleiters 04 zu reflektieren und gleichzeitig zu kollimieren. Hierdurch erfolgt die Kollimation in direkter Chipnähe, quasi durch einen durch die Ausnehmung 07, insbesondere durch eine Ausnehmung 07 mit verspiegelten Wandungen 10 gebildeten, in die Leuchteinheit 01 integrierten Reflektor.

Die Ausnehmung 07 kann so ausgeformt sein, dass der Abstand zwischen einem am Grund 08 der Ausnehmung 07 angeordneten und elektrisch kontaktierten LED-Chip 03 und wenigstens einer Wandung 10 der Ausnehmung 10 kleiner als z.B. 1 mm, besonders bevorzugt kleiner als 0,5 mm ist.

Wie in den Fig. 2, 3 und 5 zu erkennen können mehrere LED-Chips 03 in einer Ausnehmung 07 angeordnet sein. Sind zwei oder mehr LED-Chips 03 am Grund 08 einer Ausnehmung 07 angeordnet und elektrisch kontaktiert, können diese einem Abstand von z.B. weniger als 1 mm zueinander angeordnet sein. Hierdurch wird eine hohe Packungsdichte und eine damit einhergehende hohe Strahlungsflussdichte bzw. Lichtflussdichte erreicht.

Ferner können wie in Fig. 4 dargestellt mehrere Ausnehmungen 07 mit jeweils einem LED-Chip 03 an deren Grund 08 auf einem Leiterbahnträger 02 vorgesehen sein. Diese Ausnehmungen 07 können jeweils von lichteinkoppelflächenseitige Partien 09 unterschiedlicher Lichtleiter 04 zumindest abgedeckt sein, oder es können wie in Fig. 4 dargestellt mehrere lichteinkoppelflächenseitige Partien 09 eines gemeinsamen Lichtleiters 04 verschiedene Ausnehmungen 07 zumindest abdecken. Das Selbe gilt für in die Ausnehmungen 07 reichende bzw. in diesen aufgenommene Teile der lichteinkoppelflächenseitigen Partien 09.

Der Leiterbahnträger 02 kann beispielsweise plattenartig sein, oder eine beliebige, z. B. gewölbte und/oder tordierte und/oder gekrümmte Form aufweisen. Bei einer in Fig. 1 dargestellten Ausgestaltung des Leiterbahnträgers 02 als mehrlagige, plattenartige FR4-Platine, z. B. mit zwei Lagen 11, stehen für die Wärmeabfuhr zusätzliche Kupferschichten zur Verfügung, welche die Wärmeübertragung vom LED-Chip 03 an die Umgebung verbessern, indem sie die Wärmeableitung vom LED-Chip 03 weg an die Umgebung begünstigen.

Die Ausnehmung 07 oder zumindest ein Teil der Ausnehmung 07 kann wie in Fig. 1 dargestellt mit einer transparenten Vergussmasse 12 gefüllt sein, z. B mit Silikon oder einem anderem transparenten Material. Beispielsweise kann ein zwischen dem Grund 08 der Ausnehmung 07 und der Lichteinkoppelfläche 05 des Lichtleiters 04 verbleibender Raum mit der transparenten Vergussmasse 12 verfüllt sein.

Die am Grund 08 der einen Ausnehmung 07 (Fig. 1, 2, 3 und 5) bzw. am Grund der Ausnehmungen 07 (Fig. 4) angeordneten LED-Chips 03 sind in Nacktchipmontage auf den Leiterbahnträger 02 gebondet. Zur elektrischen Kontaktierung dient jeweils ein Bonddraht 13 (Fig. 1 und 5).

Der thermische Widerstand von Leuchteinheiten nach dem Stand der Technik mit einzelnen SMD- oder THT-Leuchtdioden ist zu einem Großteil bestimmt durch den Chipträger, z. B. einen Leadframe. Da bei COB-Leuchtdioden die LED-Chips direkt auf den Leiterbahnträger gebondet werden entfällt dieser Teil des thermischen Widerstands komplett. Dies führt zu einer guten Wärmeankopplung des LED-Chips, was wiederum zu einer geringen Degradation der vom LED-Chip emittierten Lichtleistung aufgrund der geringeren Erwärmung führt. Bei der Nacktchipmontage entfällt somit eine durch einen ansonsten vorhandenen Chipträger, z. B. einen Leadframe vorhandene Begrenzung der Wärmeleitfähigkeit zwischen LED-Chip 03 und Leiterbahnträger 02. Dies führt zu einer guten Wärmeankopplung des LED-Chips 03 und zu einer geringen Degradation der vom LED-Chip 03 emittierten Lichtleistung aufgrund einer geringeren Erwärmung.

An dem Leiterbahnträger 02 und/oder an dem Lichtleiter 04 können miteinander korrespondierende Ausrichtungsmittel zur Ausrichtung der Lichteinkoppelfläche 05 (Fig. 2, 3, 6 und 7) bzw. der Lichteinkoppelflächen 05 (Fig. 4) des Lichtleiters 04 gegenüber dem mindestens einen am Grund 08 der wenigstens einen Ausnehmung 07 des Leiterbahnträgers 02 angeordneten LED-Chip 03 vorgesehen sein.

Die Ausrichtungsmittel können beispielsweise durch eine am Lichtleiter 04 einseitig oder mehrseitig oder um die Ausnehmung 07 wenigstens abdeckende lichteinkoppelflächenseitigen Partie 09 herum angeordnete Auflageplatte 14 gebildet sein. Diese bildet bevorzugt die Oberflächengestalt des Leiterbahnträgers 02 nach. Sie kann beispielsweise dazu dienen, den auf dem Leiterbahnträger 02 aufstehenden Lichtleiter 04 gegen ein Verkippen sowohl während der Montage, als auch im Einsatz z. B. in einer Kraftfahrzeugleuchte zu stabilisieren.

Wichtig ist hervorzuheben, dass auch Kombinationen der zuvor genannten Ausrichtungsmittel vorgesehen sein können, z. B. Bohrungen und korrespondierende Stifte bzw. Fortsätze und/oder in wenigstens ein Ausnehmung 07 ragende Teile lichteinkoppelflächenseitiger Partien 09 und/oder eine oder mehrere Auflageplatten 14.

Ebenso wichtig ist hervorzuheben, dass Aufbauten nach dem Stand der Technik immer mit einer gewissen Bauhöhe versehen sind. Diese Bauhöhe beinhaltet dabei den Leiterbahnträger, z. B. eine Platine, eine Leuchtdiode bestehend aus einem von einer zumindest in Abstrahlrichtung transparenten Umspritzung umhüllten LED-Chip, sowie die Lichteinkoppelfläche des Lichtleiters. Zwar sind nacktmontierte, so genannte COB-Leuchtdioden bekannt, ebenso wie eine Einkopplung in einen Lichtleiter mit COB-Leuchtdioden bekannt ist. Diese sind allerdings aufgrund ihrer freiliegenden Silikon-Linse empfindlich gegenüber äußerer Krafteinwirkung.

Bei bestimmten Lichtleiter-Anwendungen ist jedoch ein möglichst geringer Aufbau notwendig oder gefordert, um die Einkoppelhöhe vor bzw. hinter dem Lichtleiter gering zu halten. Ein Beispiel sind Leuchten im Automobilbereich, insbesondere zweigeteilte Leuchten mit einer Heckdeckelleuchte und einer Seitenwandleuchte. Um einen möglichst durchgängigen Farbeindruck zwischen Heckdeckelleuchte und Seitenwandleuchte zu erhalten muss der Abstand der Lichtleiter möglichst gering sein. Durch Verwendung einer Leuchteinheit 01 ist es möglich im Vergleich zum Stand der Technik den Totraum zwischen den beiden Lichtleitern der Seitenwandleuchte und Heckdeckelleuchte zu verringern.

Des Weiteren ist bei der erfindungsgemäßen Leuchteinheit 01 der Abstand der LED-Chips 03 zueinander auf ein durch die Außenmaße der LED-Chips 03 gegebenes Minimum begrenzt. Dadurch können im Vergleich zu einer beim Stand der Technik vorgesehenen Aneinanderreihung von Leuchtdioden die LED-Chips 03 in wesentlich geringerem Abstand zueinander positioniert werden.

Die Erfindung ist insbesondere in Verbindung mit der Herstellung von Leuchten für Fahrzeuge, vor allem Leuchten für Kraftfahrzeuge sowie von Leuchteinheiten hierzu gewerblich anwendbar. Eine Leuchte erfüllt z. B. bei einem Kraftfahrzeug je nach Ausgestaltung verschiedene Aufgaben bzw. Funktionen, wie beispielsweise bei einer Ausgestaltung als Scheinwerfer eine die Fahrbahn ausleuchtende Funktion, oder bei einer Ausgestaltung als Signalleuchte eine Signalfunktion, wie beispielsweise zur Fahrtrichtungsanzeige oder Anzeige einer Bremstätigkeit, oder einer Sicherstellung einer Sichtbarkeit des Kraftfahrzeugs bei Tag und/oder Nacht. Beispiele für Leuchten sind am Fahrzeugbug, an den Fahrzeugflanken und/oder in oder an den Außen- bzw. Seitenspiegeln sowie am Fahrzeugheck angeordnete Blinkleuchten, Ausstiegsleuchten, beispielsweise zur Umfeldbeleuchtung, Begrenzungsleuchten, Bremsleuchten, Nebelleuchten, Rückfahrleuchten, sowie typischerweise hoch gesetzte dritte Bremsleuchten, so genannte Central, High-Mounted Braking Lights, Tagfahrleuchten, Scheinwerfer und auch als Abbiege- oder Kurvenlicht verwendete Nebelscheinwerfer, sowie Kombinationen hiervon. Die Erfindung kann für jegliche Art solcher Leuchten als Leuchtmittel eingesetzt werden.

## Patentansprüche

1. Leuchteinheit (01) mit einem Leiterbahnträger (02), wenigstens einem auf dem Leiterbahnträger (02) angeordneten und elektrisch kontaktierten LED-Chip (03) und mindestens einem Lichtleiter (04) mit zumindest einer in Abstrahlrichtung vor wenigstens einem LED-Chip (03) angeordneten Lichteinkoppelfläche (05), wobei der Leiterbahnträger (02) mindestens eine Ausnehmung (07) aufweist, auf deren Grund (08) wenigstens ein LED-Chip (03) angeordnet und elektrisch kontaktiert ist, welche mindestens eine Ausnehmung (07) die Kontur zumindest einer Lichteinkoppelfläche (05) mindestens eines Lichtleiters (04) nachbildet und zumindest ein Teil der zumindest eine Ausnehmung (07) abdeckenden lichteinkoppelflächenseitigen Partie (09) mindestens eines Lichtleiters (04) in die Ausnehmung (07) reicht, **dadurch gekennzeichnet, dass** der LED-Chip (03) in Nacktchipmontagetechnik (COB; Chip-On-Board) unmittelbar auf den Leiterbahnträger (02) gebondet (13) ist und zumindest eine lichteinkoppelflächenseitige Partie (09) mindestens eines Lichtleiters (04) wenigstens die mindestens eine Ausnehmung (07) abdeckt, sowie an dem Leiterbahnträger (02) und/oder an dem Lichtleiter (04) miteinander korrespondierende Ausrichtungsmittel (14) zur fluchtenden Ausrichtung der Lichteinkoppelfläche (05) des Lichtleiters (04) gegenüber dem mindestens einen am Grund (08) der wenigstens einen Ausnehmung (07) des Leiterbahnträgers (02) angeordneten LED-Chip (03) vorgesehen sind.

2. Leuchteinheit nach Anspruch 1, **dadurch gekennzeichnet, dass** die Wandungen (10) der Ausnehmung (07) mit einer reflektierenden Beschichtung versehen sind.

3. Leuchteinheit nach Anspruch 1 oder 2, **gekennzeichnet durch** an dem Leiterbahnträger (02) und/oder an zumindest einem Lichtleiter (04) angeordnete Befestigungsmittel zur mechanischen Kopplung und Verbindung von Lichtleiter (04) und Leiterbahnträger (2).

4. Leuchteinheit nach Anspruch 3, **dadurch gekennzeichnet, dass** die Befestigungsmittel an dem Leiterbahnträger (02) und an dem Lichtleiter (04) angeordnete, miteinander korrespondierende Rastmittel umfassen.

5. Leuchteinheit nach einem der vorhergehenden Ansprüche, **dadurch gekennzeichnet, dass** ein zwischen dem Grund (08) der Ausnehmung (07) und der Lichteinkoppelfläche (05) innerhalb der Ausnehmung (07) verbleibender Raum mit einer transparenten Vergussmasse (12) verfüllt ist.

6. Leuchteinheit nach einem der Ansprüche 1 bis 4, **dadurch gekennzeichnet, dass** die Ausnehmung (07) oder zumindest ein Teil der Ausnehmung (07) mit einer transparenten Vergussmasse (12) gefüllt ist.

7. Leuchteinheit nach einem der vorhergehenden Ansprüche, **dadurch gekennzeichnet, dass** die Lichteinkoppelfläche (05) wenigstens eine konkave Aussparung aufweist.

8. Leuchteinheit nach einem der vorhergehenden Ansprüche, **gekennzeichnet durch** zwei oder mehr am Grund einer Ausnehmung (07) in einem Abstand von weniger als 2 mm, bevorzugt von weniger als 1 mm zueinander angeordnete und elektrisch kontaktierte LED-Chips (03).

9. Leuchteinheit nach einem der vorhergehenden Ansprüche, **gekennzeichnet durch** eine am Lichtleiter (04) ein- oder mehrseitig oder um die Ausnehmung (07) wenigstens abdeckende lichteinkoppelflächenseitigen Partie (09) herum angeordnete Auflageplatte (14).

10. Leuchteinheit nach einem der vorhergehenden Ansprüche, **dadurch gekennzeichnet, dass** bei einem in die Ausnehmung ragenden Teil der lichteinkoppelseitigen Partie (09) des Lichtleiters (04) in der Ausnehmung (07) und an dem in der Ausnehmung (07) aufgenommenen Teil der lichteinkoppelflächenseitigen Partie (09) des Lichtleiters (04) miteinander korrespondierende Ausrichtungsmittel zur fluchtenden Ausrichtung vorgesehen sind.

11. Leuchteinheit nach einem der vorhergehenden Ansprüche, **dadurch gekennzeichnet, dass** am Rand der Ausnehmung (07) oder neben dem Rand der Ausnehmung (07) oder auf der die Öffnung der Ausnehmung (07) aufweisenden Seite des Leiterbahnträgers (02) und an entsprechenden angrenzenden Flächen des Lichtleiters (04) korrespondierende Ausrichtmittel vorgesehen sind.

12. Leuchteinheit nach einem der vorhergehenden Ansprüche, **dadurch gekennzeichnet, dass** die Ausrichtungsmittel durch den Lichtleiter (04) mit dem Leiterbahnträger (02) verrastende Rastmittel gebildet werden.

13. Leuchteinheit nach einem der vorhergehenden Ansprüche, **dadurch gekennzeichnet, dass** die Ausrichtungsmittel durch Zentrierbohrungen oder Zentrierfräsungen gebildet sind.

14. Leuchteinheit nach einem der vorhergehenden Ansprüche, **dadurch gekennzeichnet, dass** der in der Ausnehmung reichende Teil der lichteinkoppelflächenseitigen Partie (09) als ein Ausrichtungsmittel dient.

## Claims

1. Lighting unit (01) with a strip conductor support (02), at least one electrically contacted LED chip (03) arranged on the strip conductor support (02), and at least one light guide (04) with at least one light coupling surface (05) arranged before at least one LED chip (03) in direction of radiation, wherein the strip conductor support (02) comprises at least one recess (07) at the base (08) of which at least one LED chip (03) is arranged and electrically contacted, wherein the at least one recess (07) traces the outline of at the least one light coupling surface (05) of the at least one light guide (04) and wherein at least one portion of the at least one light guide's (04) section (09) located towards the light coupling surface covers the at least one recess (07) and protrudes into said recess (07), **characterized in that** the LED chip (03) is bonded (13) directly onto the strip conductor support (02) using chip-on-board (COB) technique, and **in that** at least one section (09) of the at least one light guide (04) leastwise covers the at least one recess (07), with said section (09) being located towards the light coupling surface, as well as **in that** alignment means (14) are provided at the strip conductor support (02) and/or at the light guide (04), with said alignment means (14) corresponding to each other and being provided for true alignment of the light guide's (04) light coupling surface (05) to the at least one LED chip (03) arranged at the base (08) of the at least one recess (07) of the strip conductor support (02).

2. Lighting unit according to claim 1, **characterized in that** the walls (10) of the recess (07) are provided with a reflective coating.

3. Lighting unit according to claim 1 or 2, **characterized by** fastening means arranged on the strip conductor support (02) and/or on the at least one light guide (04) for the purpose of mechanically coupling and bonding the light guide (04) and the strip conductor support (02).

4. Lighting unit according to claim 3, **characterized in that** the fastening means comprise catch means corresponding to each other and arranged on the strip conductor support (02) and on the light guide (04).

5. Lighting unit according to one of the previous claims, **characterized in that** the space remaining within the recess (07) between the base (08) of the recess (07) and the light coupling surface (05) is filled with a transparent potting compound (12).

6. Lighting device according to one of the claims 1 to 4, **characterized in that** the recess (07) or at least part of the recess (07) is filled with a transparent potting compound (12).

7. Lighting unit according to one of the previous claims, **characterized in that** the light coupling surface (05) comprises at least one concave opening.

8. Lighting unit according to one of the previous claims, **characterized by** two or more electrically contacted LED chips (03) arranged at the base of a recess (07) and spaced at less than 2 mm, preferably at less than 1 mm apart from one another.

9. Lighting unit according to one of the previous claims, **characterized by** a support plate (14) arranged on the light guide (04) on one or more sides or around at least the section (09) located towards the light coupling surface covering the recess (07).

10. Lighting unit according to one of the previous claims, **characterized in that** mutually corresponding alignment means for true alignment are provided in the recess (07) and at the portion of the light guide's (04) section (09) located towards the light coupling surface received into the recess (07) in the instance that said portion of the light guide's (04) section (09) which is located towards the light coupling surface protrudes into the recess (07).

11. Lighting unit according to one of the previous claims, **characterized in that** mutually corresponding alignment means are provided at the edge of the recess (07), or next to the edge of the recess (07), or on the side of the strip conductor support (02) comprising the opening of the recess (07) and at the appropriate, adjacent surfaces of the light guide (04).

12. Lighting unit according to one of the previous claims, **characterized in that** the alignment means are formed by catch means that are used for interlocking the light guide (04) with the strip conductor support (02).

13. Lighting unit according to one of the previous claims, **characterized in that** the alignment means are formed by center holes or center grooves.

14. Lighting device according to one of the previous claims, **characterized in that** the portion of the section (09) located towards the light coupling surface and protruding into the recess serves as an alignment means.

## Revendications

1. Unité d'éclairage (01) avec un support de pistes conductrices (02), au moins une puce à DEL (03) électriquement contactée disposée sur le support de pistes conductrices (02) et au moins un guide d'onde optique (04) avec au moins une surface de couplage de lumière (5) disposée dans le sens de rayonnement avant au moins un puce à DEL (03), étant donné que le support de pistes conductrices (02) présente au moins un évidement (07) sur la base (08) duquel est disposée au moins une puce à DEL (03) électriquement contactée, étant donné que le au moins un évidement (07) reproduit le contour d'au moins une surface de couplage de lumière (05) d'au moins un guide d'onde optique (04) et au moins une partie de la partie (09) côté surface de couplage de lumière d'au moins un guide d'onde optique (04) recouvrant au moins un évidement (07) s'étend dans l'évidement (07), **caractérisé en ce que** la puce à DEL (03) est soudée fin (13) en technique COB (Chip-On-Board) directement sur le support de pistes conductrices (02) et au moins une partie (09) côté surface de couplage de lumière d'au moins un guide d'onde optique (04) recouvre au moins le au moins un évidement (07), ainsi que sont prévus sur le support de pistes conductrices (02) et/ou sur le guide d'onde optique (04) des moyens d'alignement (14) correspondant l'un avec l'autre pour assurer l'alignement précis de la surface de couplage de lumière (05) du guide d'onde optique (04) par rapport à la au moins une puce à DEL (03) disposée sur la base (08) du au moins un évidement (07) du support de pistes conductrices (02).

2. Unité d'éclairage selon la revendication 1, **caractérisée en ce que** les parois (10) de l'évidement (07) sont dotées d'un revêtement réfléchissant.

3. Unité d'éclairage selon la revendication 1 ou 2, **caractérisée par** des moyens de fixation disposés sur le support de pistes conductrices (02) et/ou sur au moins un guide d'onde optique (04) pour le couplage et le raccordement mécaniques du guide d'onde optique (04) avec le support de pistes conductrices (2).

4. Unité d'éclairage selon la revendication 3, **caractérisée en ce que** les moyens de fixation comprennent des moyens d'arrêt correspondant l'un avec l'autre et disposés sur le support de pistes conductrices (02) et sur le guide d'onde optique (04).

5. Unité d'éclairage selon l'une quelconque des revendications précédentes, **caractérisée en ce que** un espace restant entre la base (08) de l'évidement (07) et la surface de couplage de lumière (05) au sein de l'évidement (07) est rempli avec une masse de remplissage (12) transparente.

6. Unité d'éclairage selon l'une quelconque des revendications 1 à 4, **caractérisée en ce que** l'évidement (07) ou au moins une partie de l'évidement (07) est rempli(e) avec une masse de remplissage (12) transparente.

7. Unité d'éclairage selon l'une quelconque des revendications précédentes, **caractérisée en ce que** la surface de couplage de lumière (05) présente au moins un évidement concave.

8. Unité d'éclairage selon l'une quelconque des revendications précédentes, **caractérisée par** deux ou plusieurs puces à DEL (03) électriquement contactées disposées à la base d'un évidement (07) avec un écartement de moins de 2 mm, de préférence moins de 1 mm l'une par rapport à l'autre.

9. Unité d'éclairage selon l'une quelconque des revendications précédentes, **caractérisée par** une plaque d'appui (14) disposée sur un ou plusieurs côtés sur le guide d'onde optique (04) ou tout autour de la partie (09) côté surface de couplage de lumière recouvrant au moins l'évidement (07).

10. Unité d'éclairage selon l'une quelconque des revendications précédentes, **caractérisée en ce que** des moyens d'alignement correspondant l'un avec l'autre sont prévus dans une partie, faisant saillie dans l'évidement, de la partie (09) côté couplage de lumière du guide d'onde optique (04) dans l'évidement (07) et dans la partie, logée dans l'évidement (07), de la partie (09) côté surface de couplage de lumière du guide d'onde optique (04) pour assurer l'alignement précis.

11. Unité d'éclairage selon l'une quelconque des revendications précédentes, **caractérisée en ce que** des moyens d'alignement correspondants sont prévus au bord de l'évidement (07) ou à côté de l'évidement (07) ou sur le côté du support de pistes conductrices (02) présentant l'ouverture de l'évidement (07) et sur des surfaces adjacentes correspondantes du guide d'onde optique (04).

12. Unité d'éclairage selon l'une quelconque des revendications précédentes, **caractérisée en ce que** les moyens d'alignement sont formés par des moyens d'arrêt qui enclenchent le guide d'onde optique (04) avec le support de pistes conductrices (02).

13. Unité d'éclairage selon l'une quelconque des revendications précédentes, **caractérisée en ce que** les moyens d'alignement sont formés par des alésages de centrage ou des fraisages de centrage.

14. Unité d'éclairage selon l'une quelconque des revendications précédentes, **caractérisée en ce que** la partie, s'étendant dans l'évidement, de la partie (09) côté surface de couplage de lumière sert de moyen d'alignement.
